# EUROPÄISCHE PATENTANMELDUNG

(11) **EP 4 040 504 A1**
(43) Veröffentlichungstag der Anmeldung: **10.08.2022**
(21) Anmeldenummer: 22000021.0
(22) Anmeldetag: 01.02.2022
(51) Int. Cl.: H01L 29/861, H01L 29/20, H01L 29/36

(54) **STAPELFÖRMIGE III-V-HALBLEITERDIODE**

(30) Priorität: 08.02.2021 DE 102021000609
(71) Anmelder: 3-5 Power Electronics GmbH, 01217 Dresden (DE)
(72) Erfinder: Kowalsky, Jens, 15859 Storkow (DE); Dudek, Volker, 76275 Ettlingen (DE); Bhojani, Riteshkumar, 09126 Chemnitz (DE)
(74) Vertreter: Koch Müller Patentanwaltsgesellschaft mbH

(57) **Zusammenfassung**

Stapelförmige III-V-Halbleiterdiode umfassend oder bestehend aus GaAs mit einer hoch n-dotierten Kathodenschicht, einer hoch p-dotierten Anodenschicht und einem zwischen der Kathodenschicht und der Anodenschicht angeordneten Driftgebiet, wobei das Driftgebiet eine niedrig n-dotierte Driftschicht und eine niedrig p-dotierte Driftschicht aufweist, die n-dotierte Driftschicht zwischen der p-dotierten Driftschicht und der Kathodenschicht angeordnet ist, beide Driftschichten jeweils eine Schichtdicke von mindestens 5 µm und entlang der jeweiligen Schichtdicke ein Dotierstoffkonzentrationsmaximum von höchstens 8•10¹⁵ cm⁻³ aufweisen, die Dotierstoffkonzentrationsmaxima der beiden Driftschichten zueinander ein Verhältnis von 0,1 bis 10 aufweisen und ein Verhältnis der Schichtdicke der n-dotierten Driftschicht zu der Schichtdicke der p-dotierten Driftschicht zwischen 0,5 bis 3 beträgt.

## Beschreibung

Die Erfindung betrifft eine stapelförmige III-V-Halbleiterdiode umfassend oder bestehend aus GaAs mit einer hoch n-dotierten Kathodenschicht, einer hoch p-dotierten Anodenschicht und einem zwischen der Kathodenschicht und der Anodenschicht angeordneten Driftgebiet.

Eine hochspannungsfeste Halbleiterdiode mit einer p⁺ - n - n⁺ Struktur aus Galliumarsenid ist aus "GaAs Power Devices" von German Ashkinazi, ISBN 965-7094-19-4, Seite 8 und 9 bekannt.

Weitere stapelförmige III-V-Halbleiterdioden sind aus der EP 3 321 971 B1 sowie aus der EP 3 321 970 B1 bekannt, wobei die Halbleiterdioden eine zusätzliche Zwischenschicht zwischen dem Driftgebiet und der Kathode bzw. Anode aufweisen. Aus der EP 3 321 971 B1, der DE 10 2016 111 844 A1, der JP H06-314 801A und der DE 10 2018 000 395 A1 sind weitere Halbleiterbauelemente bekannt.

Vor diesem Hintergrund besteht die Aufgabe der Erfindung darin, eine Vorrichtung anzugeben, die den Stand der Technik weiterbildet.

Die Aufgabe wird durch eine stapelförmige III-V-Halbleiterdiode mit den Merkmalen des Patentanspruchs 1 gelöst. Vorteilhafte Ausgestaltungen der Erfindung sind Gegenstand von Unteransprüchen.

In dem Gegenstand der Erfindung wird eine stapelförmige III-V-Halbleiterdiode umfassend oder bestehend aus GaAs bereitgestellt, aufweisend eine hoch n-dotierte Kathodenschicht, eine hoch p-dotierte Anodenschicht und ein zwischen der Kathodenschicht und der Anodenschicht angeordnetes Driftgebiet.

Das Driftgebiet weist eine niedrig n-dotierte Driftschicht und eine niedrig p-dotierte Driftschicht auf, wobei die n-dotierte Driftschicht zwischen der p-dotierten Driftschicht und der Kathodenschicht angeordnet ist.

Beide Driftschichten weisen jeweils eine Schichtdicke von mindestens 5 µm und entlang der jeweiligen Schichtdicke ein Dotierstoffkonzentrationsmaximum von höchstens 8●10¹⁵ cm⁻³ auf.

Die Dotierstoffkonzentrationsmaxima der beiden Driftschichten zueinander weisen ein Verhältnis von 0,1 bis 10 auf.

Ein Verhältnis der Schichtdicke der n-dotierten Driftschicht zu der Schichtdicke der p-dotierten Driftschicht liegt zwischen 0,5 bis 3.

Es versteht sich, dass alle Halbleiterschichten einer aus GaAs bestehenden oder GaAs umfassenden Halbleiterdiode, also insbesondere die Kathodenschicht, die Anodenschicht und das Driftgebiet, jeweils aus GaAs bestehen oder GaAs zumindest umfassen.

Anders ausgedrückt jede Halbleiterschicht der III-V-Halbleiterdiode weist mindestens die Elemente Ga und As auf.

Die Halbleiterschichten werden vorzugsweise mittels Epitaxie erzeugt. In einer Weiterbildung lässt sich die Kathodenschicht oder die Anodenschicht durch eine Substratschicht ausbilden. Vorzugsweise werden auf der Substratschicht weitere III-V-Halbleiterschichten epitaktisch gewachsen, um die III-V Halbleiterdiode auszubilden.

Alternativ umfasst der die III-V Halbleiterdiode wenigstens einen Halbleiterbond. Hierbei werden Oberflächen von zwei GaAs Halbleiterscheiben bzw. GaAs-Wafer zusammengefügt.

Vorzugswelse wird die Dotierung der jeweiligen GaAs Halbleiterschichten während der Epitaxie eingebracht. Vorzugsweise wird die Epitaxie mittels MOVPE und / oder LPE durchgeführt.

In einer Weiterbildung wird die Dotierung mittels Ionenimplantation zusätzlich nach dem epitaktischen Wachsen oder alternativ anstelle dem Einbringen während der Epitaxie durchführen.

Außerdem versteht es sich, dass die Halbleiterdiode vorzugsweise weitere Schichten aus anderen Materialien, insbesondere metallische Anschlusskontaktschichten, aufweist. Die Anschlusskontaktschichten bestehen beispielsweise vollständig oder teilweise aus einem Metall, z.B. Gold, oder aus einer Metalllegierung und sind beispielsweise mittels Elektronenstrahlverdampfung oder mittels Sputterns erzeugt.

Zumindest der an eine Anschlusskontaktschicht angrenzende Bereich der Kathodenschicht sowie der Anodenschicht weist bevorzugt eine hohe Dotierstoffkonzentration auf, um eine möglichst niederohmigen Kontakt auszubilden und den Serienwiderstand bzw. die Verlustleistung der Halbleiterdiode so gering wie möglich zu halten.

Das Driftgebiet zeichnet sich durch eine Gesamtbreite von mindestens 10 µm aus. Vorzugsweise beträgt die Gesamtbreite mindestens 20 µm oder mindestens 40 µm oder mindestens 60 µm. Die Gesamtbreite teilt sich auf einen schwach p-dotierten und einen schwach n-dotierten Bereich bzw. Schicht auf.

Das Verhältnis der Schichtdicken der beiden Driftschichten wird so gewählt, dass die n-dotierte Driftschicht mindestens halb so dick ist wie die p-dotierte Driftschicht bzw. dass die n-dotierte Driftschicht höchstens dreimal so dick ist wie die p-dotierte Driftschicht.

Die jeweilige Dotierstoffkonzentration der beiden Driftschichten ist jeweils in einem an die andere Driftschicht angrenzenden Bereich möglichst niedrig und steigt gegebenenfalls in einer von der anderen Driftschicht weg zeigenden Richtung etwas an. In einer Weiterbildung wird der Anstieg mittels einen oder mehreren Stufen ausführen.

Der p-n Übergang bildet sich somit innerhalb des Driftgebiets und in einem Bereich mit sehr niedrigen Dotierstoffkonzentrationen aus.

Durch das breite und aus zwei unterschiedlich niedrig dotierten Schichten bestehende Driftgebiet lassen sich Dioden mit besonders hohen Sperrspannungen von über 1100 V oder sogar über 1200 V erreichen und mit kleinen Einschaltwiderständen sowie besonders geringen Kapazitäten pro Fläche herstellen.

In einer Weiterbildung werden in die p-dotierte Driftschicht und / oder die Anodenschicht isolelektrischen bzw. isovalenten Zentren eingebaut, um die Schaltgeschwindigkeit, d.h. den Wechsel zwischen Rückwärts und Vorwärtsrichtung zu erhöhen. Hierbei stellen die isoelektrischen bzw. isovalenten Zentren Störstellenkomplexe dar. Die Störzellenkomplexe sind energetisch tiefliegend und reduzieren die Ladungsträgerlebensdauer erheblich d.h. die Zentren räumen insbesondere im Rückwärtsbetrieb die Ladungsträger aus.

In einer Ausführungsform umfassen die isoelektrischen Zentren N und / oder Zn-0 und / oder Mn und / oder ein Element aus der III und / oder ein Element der V Hauptgruppe.

In einer anderen Weiterbildung liegt die Konzentration der isoelektrischen Zentren in einem Bereich zwischen 5●10¹¹ cm⁻³ und 8●10¹⁴ cm⁻³ oder in einem Bereich zwischen 5●10¹² cm⁻³ und 1●10¹⁴ cm⁻³ oder in einem Bereich zwischen 1●10¹³ cm⁻³ und 8●10¹³ cm⁻³ Vorzugsweise liegt die Konzentration der isoelektrischen Zentren um einen Faktor 1000 bis zu einem Faktor 10 oder um einen Faktor 100 bis zu einem Faktor 20 unterhalb der Dotierstoffkonzentration des jeweiligen Bereichs der Driftschicht oder der Anodenschicht.

Insbesondere lassen sich GaAs-Leistungsdioden mit einer Sperrverzugsladung (Reverse Recovery Charge) von höchstens 80 nC pro 1mm Diodenfläche herstellen.

In einer Ausführungsform Ist die Schichtdicke der n-dotierten Driftschicht größer als die Schichtdicke der p-dotierten Driftschicht. In einer anderen Ausführungsform weist die n-dotierte Driftschicht und / oder die p-dotierte Driftschicht eine Schichtdicke von mindestens 20 µm oder mindestens 40 µm auf. Die besonders hohe Schichtdicke beider Driftschichten ermöglicht es insbesondere die Spannungsfestigkeit der Diode zu verbessern.

In einer Weiterbildung weist die n-dotierte Driftschicht entlang der Schichtdicke einen in Richtung der Kathodenschicht bis zu dem Dotierstoffkonzentrationsmaximum ansteigenden Dotierstoffkonzentrationsverlauf auf.

Das langsame Reduzieren der Dotierstoffkonzentration der n-dotierten Driftschicht in Richtung der p-dotierten Driftschicht ermöglicht es insbesondere, sehr niedrige Dotierstoffkonzentrationen zu erreichen und einen kontrollierten und reproduzierbaren p-n Übergang herzustellen.

In einer anderen alternativen Weiterbildung weist die p-dotierte Driftschicht entlang der Schichtdicke einen in Richtung der Anodenschicht bis zu dem Dotierstoffkonzentrationsmaximum ansteigenden Dotierstoffkonzentrationsverlauf auf. Wie bereits ausgeführt, lässt sich der Anstieg auch mittels eines stufenförmigen d.h. treppenförmigen Verlaufs durchführen.

Der ansteigende Dotierstoffkonzentrationsverlauf ist in alternativen Ausführungsformen linear oder konkav oder konvex ausgebildet. Ein konvexer Anstieg folgt beispielsweise einer Gausskurve, ein konkaver Anstieg beispielsweise einer Exponentialfunktion. Es versteht sich, dass der Konzentrationsverlauf immer geringer als die maximale Dotierung von 8●10¹⁵ cm⁻³ ist.

In einer anderen Weiterbildung weist der Dotierstoffkonzentrationsverlauf der n-dotierten Driftschicht und / oder der p-dotierten Driftschicht entlang der Schichtdicke eine oder mehrere Stufen auf. Eine Stufe oder mehrere Stufen oder jede Stufe weist in alternativen Weiterbildungen eine konvexe Flanke oder eine konkave Flanke oder eine lineare Flanke auf.

In einer anderen Ausführungsform fällt der Dotierstoffkonzentrationsverlauf der beiden Driftschichten jeweils in Richtung der anderen Driftschicht auf einen Wert kleiner als 3●10¹⁵ cm⁻³ oder kleiner als 6●10¹⁴ cm⁻³ oder kleiner als 3●10¹⁴ cm⁻³ oder kleiner als 2●10¹⁴ cm⁻³ ab.

In einer Weiterbildung ist die Dotierstoffkonzentration entlang wenigstens 80% Dicke der n-dotierten Driftschicht und / oder der p-dotierten Driftschicht größer als 5●10¹³ cm⁻³.

In einer weiteren Ausführungsform weist die Kathodenschicht eine Dotierstoffkonzentration von mindestens 1●10¹⁸ cm⁻³ oder von mindestens 5●10¹⁸ cm⁻³ oder von mindestens 8●10¹⁸ cm⁻³ auf.

In einer weiteren Ausführungsform weist die Anodenschicht eine Dotierstoffkonzentration von mindestens 1●10¹⁷ cm⁻³ oder von mindestens 5●10¹⁷ cm⁻³ oder von mindestens 8●10¹⁸ cm⁻³ auf. Die geringe Dotierung ermöglicht es das Abschaltverhalten der Diode zu verbessern und die Sperrverzugsladung zu verkleinern.

Es versteht sich, dass insbesondere in einem an die metallischen Anschlusskontakte angrenzenden Bereich der Kathoden- und Anoden-schicht eine möglichst hohe Dotierstoffkonzentration angestrebt wird, um den Serienwiderstand der Diode möglichst gering zu halben bzw. einen möglichst niederohmigen Kontakt herzustellen.

In einer anderen Weiterbildung weist die Kathodenschicht und/oder die Anodenschicht eine Schichtdicke von mindestens 2 µm oder mindestens 5 µm oder mindestens 20 µm auf. Eine geringe Schichtdicke erleichterte es, den Serienwiderstand der Diode gering zu halten.

In einer weiteren Weiterbildung umfasst die Kathodenschicht und / oder die Anodenschicht einen ersten Abschnitt mit einem konstanten Dotierstoffkonzentrationsverlauf und einen zwischen dem ersten Abschnitt und dem Driftgebiet angeordneten zweiten Abschnitt mit einem in Richtung des ersten Abschnitts linear und/oder konkav und/oder stufenförmig ansteigenden Dotierstoffkonzentrationsverlauf. Vorzugsweise umfasst oder besteht der stufenförmige Dotierstoffkonzentrationsbereich aus einer Stufe oder aus zwei Stufen oder aus drei Stufen.

Der zweite Schichtabschnitt ermöglicht es insbesondere, den Übergang der Dotierstoffkonzentration von dem niedrigen Niveau im Bereich des Driftgebiets zu einem deutlich höheren Niveau des zweiten Abschnitts der Anoden- und / oder Kathodenschicht zu gestalten.

In einer Ausführungsform weist der zweite Schichtabschnitt wenigstens eine Stufe oder weist genau eine Stufe oder weist wenigstens zwei oder weist genau zwei Stufen in dem Verlauf des Dotierprofils auf.

In einer anderen Ausführungsform ist bei einer einzigen Stufe an der Oberseite der Stufe die Dotierstoffkonzentration größer als der Faktor 2 oder größer als der Faktor 5 oder größer als der Faktor 8 als die Dotierstoffkonzentration der an den zweiten Bereich angrenzenden Driftschicht.

Durch das Vermeiden eines sprunghaften Übergangs, d.h. einem Anstieg in der Dotierstoffkonzentration von 8●10¹⁵ cm⁻³ auf die Dotierstoffkonzentration des ersten Abschnitts, mittels eines graduellen oder schrittweisen Anstiegs über einen Übergangsbereich, also den zweiten Abschnitt, wird insbesondere das Abschaltverhalten der Diode deutlich verbessert.

Der zweite Abschnitt weist In einer ersten Ausführungsform eine Schichtdicke von mindestens 0,5 µm und von höchstens 10 µm auf. Bevorzugt weist der zweite Abschnitt der Kathodenschicht eine Schichtdicke von 3 µm bis 5 µm auf, während der zweite Abschnitt der Anodenschicht bevorzugt eine Schichtdicke von 2 µm bis 4 µm aufweist.

In einer anderen Weiterbildung ist die Kathodenschicht oder die Anodenschicht als Substrat ausgebildet. Typische Schichtdicken einer als Substrat ausgebildeten Anoden- oder Kathodenschicht sind 100 µm bis 250 µm.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Ansicht auf eine erste Ausführungsform einer stapelförmigen III-V-Halbleiterdioden,
- Figur 2: eine Ansicht auf eine zweite Ausführungsform der stapelförmigen III-V-Halbleiterdiode,
- Figur 3: eine Ansicht auf eine dritte Ausführungsform der stapelförmigen III-V-Halbleiterdiode,
- Figur 4: einen Dotierstoffkonzentrationsverlauf entlang der stapelförmigen III-V-Halbleiterdiode In einer weiteren Ausführungsform
- Figur 5: eine weitere Ausführungsform des Dotierstoffkonzentrationsverslaufs entlang der stapelförmigen II-V-Halbleiterdiode.

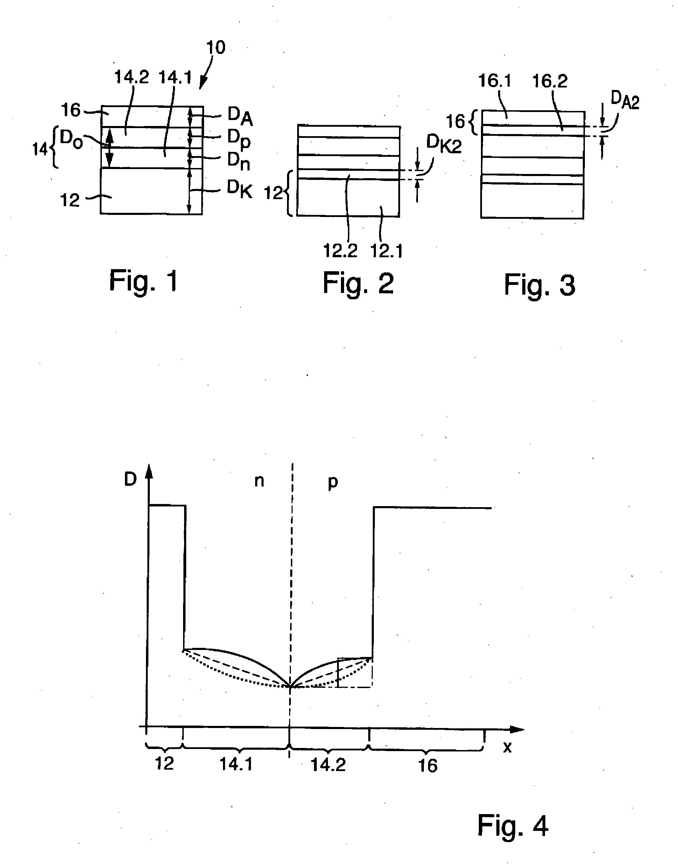

Die Abbildung der Figur 1 zeigt eine Ansicht auf eine erste Ausführungsform einer stapelförmigen III-V-Halbleiterdiode 10 aufweisend GaAs oder bestehend aus GaAs. Eine hoch n-dotierte Substratschicht bildet eine Kathodenschicht 12 aus, auf der das Driftgebiet 14 mit einer Gesamtdicke D_{D} gefolgt von einer hoch p-dotierten Anodenschicht 16 mit einer Schichtdicke D_{A} angeordnet ist.

Das Driftgebiet 14 teilt sich in eine an die Kathodenschicht 12 angrenzende schwach n-dotierte Driftschicht 14.1 mit einer Schichtdicke Dₙ und eine zwischen der n-dotierten Driftschicht 14.1 und der Anodenschicht 16 angeordnete schwach p-dotierte Driftschicht 14.2 mit einer Schichtdicke Dₚ auf.

Die durch ein Substrat ausgebildete Kathodenschicht 12 weist dementsprechend eine etwas größere Schichtdicke D_{K} von 50 µm bis 250 µm aus. Eine Dotierstoffkonzentration der Kathodenschicht beträgt bevorzugt mindestens 8●10¹⁸ cm⁻³ und ist entlang der Schichtdicke konstant oder zumindest im Wesentlichen konstant.

Die weiteren Schichten sind bevorzugt epitaktisch auf der Kathodenschicht 12 erzeugt. Die Dotierung lässt sich während der Epitaxie oder nachfolgend per Ionenimplantation erzeugen. Die Schichtdicke Dₙ der n-dotierten Driftschicht 14.1 beträgt mindestens 5 µm, bevorzugt mindestens 40 µm. Eine Dotierstoffkonzentration nimmt von einem Dotierstoffkonzentrationsmaximum von höchstens 8●10¹⁵ cm⁻³, bevorzugt von höchstens 2●10¹⁵ cm⁻³, in Richtung der p-dotierten Driftschicht 14.2 ab.

Die Schichtdicke Dₚ der p-dotierten Driftschicht 14.2 beträgt mindestens 5 µm, bevorzugt mindestens 20 µm. Bevorzugt beträgt die Schichtdicke Dₚ der p-dotierten Driftschicht 14.2 die Hälfte oder ein Drittel der Schichtdicke Dₙ der n-dotierten Driftschicht 14.1. Eine Dotierstoffkonzentration der p-dotierten Driftschicht 14.2 nimmt in Richtung der Anodenschicht 16 bis auf ein Dotierstoffkonzentrationsmaximum von mindestens 1●10¹⁷ cm⁻³ oder mindestens 1●10¹⁸ cm⁻³ zu.

In der Abbildung der Figur 2 ist eine weitere Ausführungsform dargestellt. Im Folgenden werden nur die Unterschiede zu der Abbildung der Figur 1 erläutert.

Die stapelförmige III-V-Halbleiterdiode 10 weist eine Kathodenschicht 12 mit einem ersten Abschnitt 12.1 mit einer konstanten Dotierstoffkonzentration von mindestens 1●10¹⁸ cm⁻³, bevorzugt von mindestens 8●10¹⁸ cm⁻³ sowie mit einem zweiten Abschnitt 12.2 auf. Der zweite Abschnitt 12.2 ist zwischen dem ersten Abschnitt 12.1 und dem Driftgebiet 14 angeordnet und weist eine relativ geringe Schichtdicke D_{K2} von 0,5 µm bis 10 µm, bevorzugt von 3 µm bis 5 µm, auf.

Der zweite Schichtabschnitt dient dazu, den Übergang der Dotierstoffkonzentration von dem hochdotierten ersten Abschnitt 12.1 der Kathodenschicht zu der niedrig n-dotierten Driftschicht 14.1 zu gestalten. Der zweite Abschnitt 12.2 weist hierfür einen in Richtung des ersten Abschnitts 12.1 von einem Dotierstoffkonzentrationsminimum zu einem Dotierstoffkonzentrationsmaximum ansteigenden Dotierstoffkonzentrationsverlauf auf. Der Dotierstoffkonzentrationsverlauf ist linear oder konkav oder konvex oder stufenförmig mit einer Stufe oder mit mehreren Stufen ausgebildet. Bei einem stufenförmigen Verlauf ist bevorzugt die Flanke einer Stufe oder mehrerer Stufen oder aller Stufen konvex oder konkav oder linear ausgebildet.

In einer ersten Ausführungsform entspricht das Dotierstoffkonzentrationsmaximum des zweiten Abschnitts 12.2 der Dotierstoffkonzentration des ersten Abschnitts 12.1, während das Dotierstoffkonzentrationsminimum des zweiten Abschnitts 12.2 dem Dotierstoffkonzentrationsmaximum des n-dotierten Driftgebiets entspricht. In anderen Ausführungsformen bildet sich an der Grenzfläche zwischen dem ersten und zweiten Abschnitt 12.1, 12.2 und / oder zwischen dem zweiten Abschnitt 12.2 und dem Driftgebiet 14 ein Dotierstoffkonzentrationssprung aus, wobei der Dotierstoffkonzentrationssprung aufgrund des Dotierstoffkonzentrationsverlaufs des zweiten Abschnitts 12.2 geringer ausfällt als bei einer Ausführungsform der Halbleiterdiode 10 ohne zweiten Kathodenabschnitt 12.2.

In der Abbildung der Figur 3 ist eine weitere Ausführungsform dargestellt. Im Folgenden werden nur die Unterschiede zu der Abbildung der Figur 2 erläutert.

Die stapelförmige III-V-Halbleiterdiode 10 weist eine Anodenschicht 16 mit einem ersten Abschnitt 16.1 mit einer konstanten Dotierstoffkonzentration von mindestens 1●10¹⁷ cm⁻³ sowie einen zweiten Abschnitt 16.2 mit einem in Richtung des ersten Abschnitts 16.1 ansteigenden Dotierstoffkonzentrationsprofil und einer Schichtdicke D_{A2} von 0,5 µm bis 10 µm, bevorzugt von 2 µm bis 4 µm auf.

Wie der zweite Abschnitt 12.2 der Kathodenschicht 12 dient der zweite Abschnitt 16.2 der Anodenschicht 16 dazu den Übergang der Dotierstoffkonzentration zu gestalten. Der Dotierstoffkonzentrationsverlauf des zweiten Abschnitts 16.2 ist linear oder konkav oder konvex oder stufenförmig mit einer oder mehreren Stufen ausgebildet. Bei einem stufenförmigen Verlauf ist bevorzugt die Flanke einer Stufe oder mehrerer Stufen oder aller Stufen konvex oder konkav oder linear ausgebildet.

In einer weiteren, hier nicht dargestellten Ausführungsform weist die stapelförmige III-V-Halbleiterdiode 10 die vorbeschriebene Anodenschicht 16 mit den zwei Abschnitten 16.1 und 16.2 sowie eine Driftschicht 14 In dem ersten Ausführungsbeispiel der Fig. 1, also ohne den zweiten Abschnitt 12.2 auf.

In der Abbildung der Figur 4 ist eine weitere Ausführungsform dargestellt. Im Folgenden werden nur die Unterschiede zu der Abbildung der Figur 1 erläutert.

In Figur 4 sind verschiedene Dotierstoffkonzentrationsverläufe entlang der stapelförmigen III-V-Halbleiterdiode 10 mit einer dem Ausführungsbeispiel der Figur 1 entsprechenden Schichtfolge dargestellt. Der Dotierstoffkonzentrationsverlauf der n-dotierten Driftschicht 14.1 verläuft In alternativer Ausführungsformen konvex oder konkav oder linear ansteigend in Richtung der Kathodenschicht 12.

Der Dotierstoffkonzentrationsverlauf der p-dotierten Driftschicht 14.2 verläuft in Richtung der Anodenschicht 16 In alternativen Ausführungsformen konstant oder ansteigend, wobei der Anstieg stufenförmig oder konvex oder linear oder konkav ausgebildet ist.

Der konvexe Anstieg der n-dotierten und / oder der p-dotierten Driftschicht 14.1 bzw. 14.2 ist In einer ersten Ausführungsform gaussförmig ausgebildet.

Alternativ folgt der konkave Anstieg der n-dotierten und / oder der p-dotierten Driftschicht 14.1 bzw. 14.2 In einer Ausführungsform einer exponentiellen Kurve.

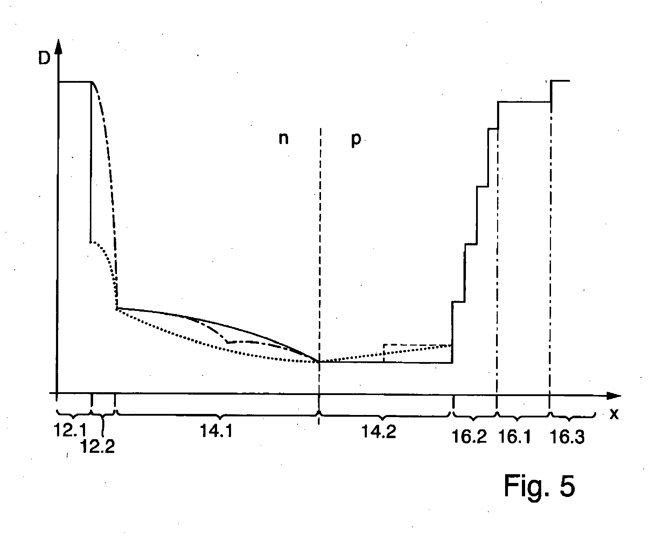

In der Abbildung der Figur 5 ist eine weitere Ausführungsform dargestellt. Im Folgenden werden nur die Unterschiede zu der Abbildung der Figur 3 erläutert.

In Figur 5 sind beispielhaft verschiedene Dotierstoffkonzentrationsverläufe entlang der stapelförmigen III-V-Halbleiterdiode 10 dargestellt.

Der Dotierstoffkonzentrationsverlauf beginnt mit einer konstanten, hohen Dotierstoffkonzentration von n-Dotierstoffen über den ersten Abschnitt 12.1 der Kathodenschicht 12, gefolgt von einem Dotierstoffkonzentrationsabfall über den zweiten Abschnitt 12.2 der Kathodenschicht, wobei der Abfall konvex ausgebildet ist und auf dem Dotierstoffkonzentrationsniveau des ersten Abschnitts 12.2 oder auf einem deutlich niedrigeren Niveau beginnt.

Anschließend fällt die Dotierstoffkonzentration über die n-dotierte Driftschicht 14.1 weiter auf ab. Die Abnahme erfolgt langsamer und mit oder ohne Stufen.

Zwischen der n-dotierten Driftschicht 14.1 und der p-dotierten Driftschicht 14.2 erfolgt ein Wechsel des Dotierstoffs, wobei die p-dotierten Driftschicht 14.2 in dem dargestellten Ausführungsbeispiel eine konstante oder linear ansteigende oder stufenförmige Konzentration von p-Dotierstoffen aufweist.

In dem an das Driftgebiet angrenzenden zweiten Abschnitt 16.2 der Anodenschicht 16 steigt die Dotierstoffkonzentration von p-Dotierstoffen treppenförmig über mehrere rechteckig ausgebildete Stufen an. Der sich anschließende erste Abschnitt 16.1 der Anodenschicht 16 weist ein konstantes Dotierstoffkonzentrationsniveau von mindestens 1●10¹⁷ cm⁻³ auf.

Zusätzlich weist die Anodenschicht 16 einen auf den ersten Abschnitt 16.1 folgenden dritten Abschnitt 16.3 auf, so dass der erste Abschnitt 16.1 zwischen dem zweiten Abschnitt 16.2 und dem dritten Abschnitt 16.3 angeordnet ist. Der dritte Abschnitt 16.3 weist eine höhere Dotierstoffkonzentration als der erste Abschnitt 16.1 auf, bevorzugt eine konstante Dotierstoffkonzentration von mindestens 5●10¹⁸ cm⁻³ oder von mindestens 1●10¹⁹ cm⁻³.

## Patentansprüche

1. Stapelförmige III-V-Halbleiterdiode (10) umfassend oder bestehend aus GaAs, aufweisend
- eine hoch n-dotierte Kathodenschicht (12),
- eine hoch p-dotierte Anodenschicht (16) und
- ein zwischen der Kathodenschicht (12) und der Anodenschicht (16) angeordnetes Driftgebiet (14),
- das Driftgebiet (14) eine niedrig n-dotierte Driftschicht (14.1) und eine niedrig p-dotierte Driftschicht (14.2) aufweist,
- die n-dotierte Driftschicht (14.1) zwischen der p-dotierten Driftschicht (14.2) und der Kathodenschicht (12) angeordnet ist,
**dadurch gekennzeichnet, dass**
- beide Driftschichten (14.1, 14.2) jeweils eine Schichtdicke (Dₙ, Dₚ) von mindestens 5 µm und entlang der jeweiligen Schichtdicke (Dₙ, Dₚ) ein Dotierstoffkonzentrationsmaximum von höchstens 8●10¹⁵ cm⁻³ aufweisen,
- die Dotierstoffkonzentrationsmaxima der beiden Driftschichten (14.1, 14.2) zueinander ein Verhältnis von 0,1 bis 10 aufweisen und
- ein Verhältnis der Schichtdicke (Dₙ) der n-dotierten Driftschicht zu der Schichtdicke (Dₚ) der p-dotierten Driftschicht zwischen 0,5 bis 3 beträgt,
die Anodenschicht (16) einen ersten Abschnitt (12.1, 16.1) mit einem konstanten Dotierstoffkonzentrationsverlauf und einen zwischen dem ersten Abschnitt (12.1, 16.1) und dem Driftgebiet (14) angeordneten zweiten Abschnitt (12.2, 16.2) mit einem in Richtung des ersten Abschnitts (12.1, 16.1) stufenförmig ansteigenden Dotierstoffkonzentrationsverlauf aufweist.

2. Stapelförmige III-V-Halbleiterdiode (10) nach Anspruch 1, **dadurch gekennzeichnet, dass** die Schichtdicke (Dₙ) der n-dotierten Driftschicht (14.1) größer ist als die Schichtdicke (Dₚ) der p-dotierten Driftschicht (14.2).

3. Stapelförmige III-V-Halbleiterdiode (10) nach Anspruch 1 oder 2, **dadurch gekennzeichnet, dass** die n-dotierte Driftschicht (14.1) und / oder die p-dotierte Driftschicht (14.2) eine Schichtdicke (Dₙ, Dₚ) von mindestens 20 µm oder mindestens 40 µm aufweist.

4. Stapelförmige III-V-Halbleiterdiode (10) nach einem der vorstehenden Ansprüche, **dadurch gekennzeichnet, dass** die n-dotierte Driftschicht (14.1) entlang der Schichtdicke (Dₙ) einen in Richtung der Kathodenschicht (12) bis zu dem Dotierstoffkonzentrationsmaximum ansteigenden Dotierstoffkonzentrationsverlauf aufweist.

5. Stapelförmige III-V-Halbleiterdiode(10) nach einem der vorstehenden Ansprüche, **dadurch gekennzeichnet, dass** die p-dotierte Driftschicht (14.2) entlang der Schichtdicke (Dₚ) einen in Richtung der Anodenschicht (16) bis zu dem Dotierstoffkonzentrationsmaximum ansteigenden Dotierstoffkonzentrationsverlauf aufweist.

6. Stapelförmige III-V-Halbleiterdiode (10) nach einem Anspruch 4 oder 5, **dadurch gekennzeichnet, dass** der ansteigende Dotierstoffkonzentrationsverlauf linear und / oder konkav und / oder konvex und / oder mehrere Stufen umfasst.

7. Stapelförmige III-V-Halbleiterdiode (10) nach einem der Ansprüche 4 oder 5, **dadurch gekennzeichnet, dass** der Dotierstoffkonzentrationsverlauf der n-dotierten Driftschicht (14.1) und / oder der p-dotierten Driftschicht (14.2) entlang der Schichtdicke (Dₙ, Dₚ) eine oder mehrere Stufen aufweist.

8. Stapelförmige III-V-Halbleiterdiode (10) nach Anspruch 7, **dadurch gekennzeichnet, dass** eine Stufe oder mehrere Stufen oder jede Stufe eine konvexe Flanke oder eine konkave Flanke oder eine lineare Flanke aufweist.

9. Stapelförmige III-V-Halbleiterdiode (10) nach einem der Ansprüche 4 bis 8, **dadurch gekennzeichnet, dass** der Dotierstoffkonzentrationsverlauf der beiden Driftschichten (14.1, 14.2) jeweils in Richtung der anderen Driftschicht (14.1, 14.2) auf einen Wert kleiner 9●10¹⁴ cm⁻³ oder kleiner 6●10¹⁴ cm⁻³ oder kleiner 3●10¹⁴ cm⁻³ oder kleiner 2●10¹⁴ cm⁻³ abfällt.

10. Stapelförmige III-V-Halbleiterdiode (10) nach einem der vorstehenden Ansprüche, **dadurch gekennzeichnet, dass** die Kathodenschicht (12) und/oder die Anodenschicht (16) eine Dotierstoffkonzentration von mindestens 1●10¹⁷ cm⁻³ oder von mindestens 5●10¹⁸ cm⁻³ oder von mindestens 8●10¹⁸ cm⁻³ aufweist.

11. Stapelförmige III-V-Halbleiterdiode (10) nach einem der vorstehenden Ansprüche, **dadurch gekennzeichnet, dass** die Kathodenschicht (12) und/oder die Anodenschicht (16) eine Schichtdicke (D_{K}, D_{A}) von mindestens 2 µm oder mindestens 5 µm oder mindestens 20 µm aufweist.

12. Stapelförmige III-V-Halbleiterdiode (10) nach einem der vorstehenden Ansprüche, **dadurch gekennzeichnet, dass** die Kathodenschicht (12) einen ersten Abschnitt (12.1, 16.1) mit einem konstanten Dotierstoffkonzentrationsverlauf und einen zwischen dem ersten Abschnitt (12.1, 16.1) und dem Driftgebiet (14) angeordneten zweiten Abschnitt (12.2, 16.2) mit einem in Richtung des ersten Abschnitts (12.1, 16.1) linear und / oder konkav und / oder stufenförmig ansteigenden Dotierstoffkonzentrationsverlauf aufweist.

13. Stapelförmige III-V-Halbleiterdiode (10) nach Anspruch 12, **dadurch gekennzeichnet, dass** der zweite Abschnitt (12.2, 16.2) eine Schichtdicke (D_{K2}, D_{A2}) von mindestens 0,5 µm und von höchstens 10 µm von mindestens 2 µm und von höchstens 4 µm aufweist.

14. Stapelförmige III-V-Halbleiterdiode (10) nach einem der vorstehenden Ansprüche, **dadurch gekennzeichnet, dass** die Kathodenschicht (12) oder die Anodenschicht (16) als Substrat ausgebildet ist.

15. Stapelförmige III-V-Halbleiterdiode (10) nach einem der vorstehenden Ansprüche, **dadurch gekennzeichnet, dass** in die p-dotierte Driftschicht und / oder die Anodenschicht isolelektrische bzw. isovalente Zentren aufweisen, um die Schaltgeschwindigkeit zu erhöhen.
